Europäisches Patentamt

European Patent Office

Office européen des brevets

(19)

(11) Veröffentlichungsnummer: **0 350 775 B1**

(12) **EUROPÄISCHE PATENTSCHRIFT**

(45) Veröffentlichungstag der Patentschrift: **23.12.92**

(51) Int. Cl.5: **H05K 9/00**

(21) Anmeldenummer: **89112261.6**

(22) Anmeldetag: **05.07.89**

(54) **Filteranordnung.**

(30) Priorität: **11.07.88 DE 3823469**

(43) Veröffentlichungstag der Anmeldung:
**17.01.90 Patentblatt 90/03**

(45) Bekanntmachung des Hinweises auf die
Patenterteilung:
**23.12.92 Patentblatt 92/52**

(84) Benannte Vertragsstaaten:
**DE ES FR GB IT**

(56) Entgegenhaltungen:
**US-A- 4 739 453**

(73) Patentinhaber: **Bodenseewerk Gerätetechnik GmbH**
**Alte Nussdorfer Strasse 15 Postfach 1120**
**W-7770 Überlingen/Bodensee(DE)**

(72) Erfinder: **Gerstenberg, Bruno**
**Mühlenstrasse 9**
**W-7776 Owingen(DE)**
Erfinder: **Michling, Hans Joachim**
**Obertorstrasse 14A**
**W-7770 Überlingen(DE)**
Erfinder: **Vachek, Josef**
**Fichtenweg 3**
**W-7770 Überlingen(DE)**

(74) Vertreter: **Weisse, Jürgen, Dipl.-Phys. et al**
**Patentanwälte Dipl.-Phys. Jürgen Weisse**
**Dipl.-Chem. Dr. Rudolf Wolgast Bökenbusch**
**41 Postfach 11 03 86**
**W-5620 Velbert 11 Langenberg(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 350 775 B1

## Beschreibung

## Technisches Gebiet

Die Erfindung betrifft eine Filteranordnung zum Filtern einer Mehrzahl von Leitungen, die aus einem elektromagnetische Felder enthaltenden Raum zu einem in einem abgeschirmten Raum befindlichen Gerät geführt sind, enthaltend

(a) eine Trennwand (24) in Form einer mehrschichtigen, mit einer internen Massefläche (32) versehenen Leiterplatte (26) mit Filtergliedern, uns

(b) zur Durchführung von Signalen Löcher in der Leiterplatte vorgesehen sind, durch welche Signalleitungen mittels Durchsteiger hindurchgeführt sind.

## Zugrundeliegender Stand der Technik

Empfindliche elektronische Geräte, beispielsweise Flug- oder Triebwerksrechner von Flugzeugen, sind in einem gegen elektromagnetische Felder abgeschirmten Raum untergebracht. Zu diesen Geräten sind Leitungen geführt, die aus einem Raum kommen, in welchem starke elektrische oder magnetische Felder hoher Frequenz auftreten können. Die Leitungen führen Nutzsignale. Diese Nutzsignale können sowohl analoge Signale sein als auch digitale Impulsfolgen. Über diese Leitungen können störende elektromagnetische Felder in den abgeschirmten Raum gelangen. Es können in den Leitungen Signale induziert werden, die den Nutzsignalen überlagert sind und die Signalverarbeitung übersteuern und "verstopfen". Aus diesem Grund sind an der Trennwand Filter vorgesehen, durch welche solche Störungen, die Frequenzen bis in den Bereich von Gigahertz haben können, eliminiert werden.

Zu diesem Zweck ist es bekannt, in der abschirmenden Trennwand Durchbrüche vorzusehen, einen Durchbruch für jede Leitung. In diesen Durchbrüchen sitzen Durchführungskondensatoren. Die Durchführungskondensatoren sind in die Trennwand eingelötet oder eingeschraubt(DE-U-77 29 132, DE-A-1 590 690). Bei diesem bekannten Verfahren ergeben sich Probleme:

Bei kleinen Geräten mit einer Vielzahl von Leitungen hat die Trennwand mit der Vielzahl von Durchführungsfiltern und Steckern ein erhebliches Gewicht. Durchführungskondensatoren mit den erforderlichen Kapazitätswerten sind teuer. Es ist weiterhin eine zusätzliche Verdrahtung einmal von dem Eingangsstecker zu den Filtern und zum anderen von den Filtern zu den im abgeschirmten Raum angeordneten Teilen des Gerätes erforderlich. Eine solche Verdrahtung muß manuell hergestellt werden, was erhebliche Kosten mit sich bringt.

Die EP-A1-0 181 286 zeigt eine geschirmte Anordnung zum Störschutz von Nachrichtenleitungen. Zwischen einem Eingangsraum und einem Ausgangsraum einer durch einen Boden und einen Deckel geschirmten Störschutz-Anordnung ist eine beidseitig bestückte zweischichtige Leiterplatte eingesetzt. Die Leiterplatte enthält zwischen den Schichten Masseschirme. Zwischen Eingangsleitungen, Ausgangsleitungen und den Masseschirmen ist ein Entstörnetzwerk mit Ableiter, Kondensatoren und Spulen vorgesehen. Diese Bauteile sind auf oder in der Leiterplatte eingelötet, geschweißt oder leitend geklebt.

Bei dieser bekannten Anordnung sind die Masseschirme nur lückenhaft vorhanden. Das Entstörnetzwerk ist von gesonderten Bauteilen gebildet, die auf der Leierplatte sitzen. Die lückenhafte Ausbildung der Masseschirme bietet keinen Schutz gegen sehr hochfrequente Störungen etwa im Gigahertzbereich. Auch das aus gesonderten Bauteilen aufgebaute Entstörnetzwerk verliert seine Filterwirkung in diesen hohen Frequenzbereichen.

Die DE-A1-34 26 278 zeigt eine Durchkontaktierung einer mehrschichtigen Leiterplatte. Dabei ist die Leiterplatte mit einer Schirmfolie zwischen den Schichten und einem Durchgangsloch versehen. Das Durchgangsloch weist eine metallische Auskleidung auf. Die Auskleidung ist mit der Schirmfolie elektrisch verbunden. Die Auskleidung trägt eine Isolierschicht, auf welcher wiederum eine leitfähige Metallschicht sitzt.

Diese Abschirmung soll dazu dienen, die Durchkontaktierung gegenüber benachbarten Durchkontaktierungen zu entkoppeln. Diese Druckschrift bezieht sich somit nicht auf die Abschirmung eines Raumes gegen elektromagnetische Felder hoher Frequenz. Zwar stellt die Auskleidung mit der Isolierschicht und der äußeren Metallschicht einen Kondensator dar, dessen eine Platte, die Metallschicht, mit der Schirmfolie leitend verbunden ist. Die Kapazität eines so aufgebauten Kondensators ist jedoch unter Zugrundelegung üblicher Abmessungen zu gering, um eine Abschirmung eines Raumes gegen die erwähnten elektromagnetischen Felder zu ermöglichen.

Die CH-A-214 067 zeigt eine Durchführung einer Leitung durch eine gegen Hochfrequenzwellen abschirmende Abschirmwand. An der Durchführungsstelle sind beide Seiten einer Metallwand mit Isolierbelegungen versehen. Die Isolierbelegungen werden von metallenen Unterlegscheiben gegen die Metallwand gedrückt. Die Unterlegscheiben bilden dabei zusammen mit der Metallwand Kondensatoren. Die Bolzen dienen als Durchführungen.

Für jede durchzuführende Leitung sind dabei Kondensatoren aus Einzelteilen aufzubauen, was fertigungstechnisch sehr aufwendig ist.

Die DD-A1-239 916 zeigt eine hochfrequenzdichte Baugruppe mit oberflächenmontierten Schaltkreisen auf einer mehrschichtigen Leiterplatte. Die Leiterplatte enthält in einer Leiterebene einen "Schirmungsträger". Dieser Schirmungsträger ist durch Kontaktstifte mit Abschirmkappen verbunden, welche die Schaltkreise abdecken und abschirmen. Es handelt sich dort nicht um die Durchführung von Signalleitungen durch eine abschirmende Trennwand zwischen einem Raum mit hochfrequenten elektromagnetischen Feldern und einem Raum, der gegen solche Felder geschützt werden soll.

Die EP-B1-0 162 146 zeigt einen geschirmten Schrank, bei welchem Filterbaugruppen in eine Montagewand eingesetzt sind. Das DE-U1-83 09 875.5 betrifft eine gedruckte Schaltungsplatine mit teilweise parallelen Leiterbahnen, wobei zwischen diesen Leiterbahnen zu deren kapazitiver Entkopplung eine Masseleitbahn angeordnet ist. Die EP-A2-0 264 105 betrifft ein Verfahren zur Herstellung von mehrschichtigen Leiterplatten, bei denen wenigstens eine Schicht von einer Metallplatte gebildet ist.

**Offenbarung der Erfindung**

Der Erfindung liegt die Aufgabe zugrunde, eine Filteranordnung der eingangs genannten Art so auszubilden, daß sie mit relativ geringem Aufwand und bei gegenüber dem Stand der Technik verringertem Gewicht eine große Anzahl von Leitungen durch eine abschirmende Trennwand hindurchzuführen gestattet und dabei Störungen bis zu sehr hohen Frequenzen herausfiltert.

Gemäß Patentanspruch 1 wird diese Aufgabe mit einer Filteranordnung gelöst, wobei

(c) die Massefläche mit Ausnahme von Durchbrüchen im Bereich der Löcher, durch welche Durchsteiger hindurchgeführt sind, durchgehend ausgebildet ist und der Abstand der Durchsteiger von der Massefläche so gering ist, daß dort hindurch keine Störfelder in den abzuschirmenden Raum gelangen können und

(d) in der mehrschichtigen Leiterplatte zusätzlich zu der internen Massefläche weitere Schichten mit leitenden Flächen vorgesehen sind, welche mit der Signalleitung elektrisch verbundene, einen Durchgang hochfrequenter elektromagnetischer Wellen durch die Löcher verhindernde Filterglieder bilden.

Als Trennwand wird somit eine mehrschichtige Leiterplatte mit einer internen Massefläche verwendet. Durch diese Massefläche wird ein Durchsteiger mit geringem Abstand von der Massefläche hindurchgeführt. Der Durchbruch ist so eng, so daß dort hindurch keine Störfelder in den abgeschirmten Raum gelangen.

Die leitenden Flächen auf den besagten weiteren Schichten der mehrschichtigen Leiterplatte bilden Filterglieder, welche hochfrequente Felder an einem geraden Durchgang durch die Löcher hindern. Diese leitenden Flächen bilden auch mit der Massefläche Kondensatoren, über welche hochfrequente Signale zur Masse abgeleitet werden.

Zu diesem Zweck können bei gerade durchgehenden Löchern die elektrisch leitenden Flächen der weiteren Schichten Kondensatoren zwischen Signalleitung und Massefläche bilden.

Es können aber auch die Löcher von engen Sacklochbohrungen gebildet sein, die sich von je einer Seite der Leiterplatte her durch Schichten der Leiterplatte bis zu je einer der an den besagten weiteren Schichten vorgesehenen leitenden Flächen erstrecken, in der Leiterplatte weitere Bohrungen vorgesehen sein, die sich zwischen den leitenden Flächen an den weiteren Schichten erstrecken und gegenüber den zugehörigen Sacklochbohrungen seitlich versetzt sind, und Durchsteiger in den Sacklochbohrungen und den besagten weiteren Bohrungen durch die Durchbrüche hindurchgeführt und mit den besagten leitenden Flächen elektrisch verbunden sein. Auf diese Weise wird ein "Umweg" für die hochfrequenten Felder geschaffen. Auf diesem Umweg werden die hochfrequenten Felder gedämpft. Die leitenden Flächen der weiteren Schichten bilden auch hier Kondensatoren mit der Massefläche, über den die hochfrequenten Felder zur Masse abgeleitet werden.

Weiterhin können Filterbauteile als SMD-Bauteile (surface mounted device) ausgebildet und auf der Leiterkarte montiert sein.

Filterbauteile können sowohl auf der Seite des elektromagnetische Felder enthaltenden Raumes als auch auf der Seite des abgeschirmten Raumes angeordnet sein.

Die Massefläche kann an den Rändern der Leiterplatte nach außen geführt sein und mit einem sich rings um die Leiterplatte erstreckenden elektrisch leitenden Kontakt verbunden sein, und der sich um die Leiterplatte erstreckende Kontakt kann auf seinem gesamten Umfang elektrisch gut leitend mit einem abschirmenden Gehäuse verbunden sein.

Ein Ausführungsbeispiel der Erfindung ist nachstehend unter Bezugnahme auf die zugehörigen Zeichnungen näher erläutert.

**Kurze Beschreibung der Zeichnungen**

Fig.1 zeigt einen abgebrochenen Schnitt durch ein Gerät, dessen Bauteile in einem abgeschirmten Raum angeordnet sind, welcher von einem elektromagnetische Felder enthaltenden Außenraum durch eine abschirmende Trennwand getrennt ist, durch die eine Vielzahl von Leitungen unter Filterung mittels an der Trennwand vorgesehener Filter zu dem Gerät hindurchgeführt sind.

Fig.2      zeigt eine Einzelheit A von Fig.1 in vergrößertem Maßstab.

Fig.3      zeigt in einem Schnitt ähnlich Fig.2 eine abgewandelte Ausführung einer Filteranordnung mit einem gerade durchgehenden Durchsteiger und von weiteren Lagen der Leiterplatte gebildeten Kondensatorplatten.

## Bevorzugte Ausführungen der Erfindung

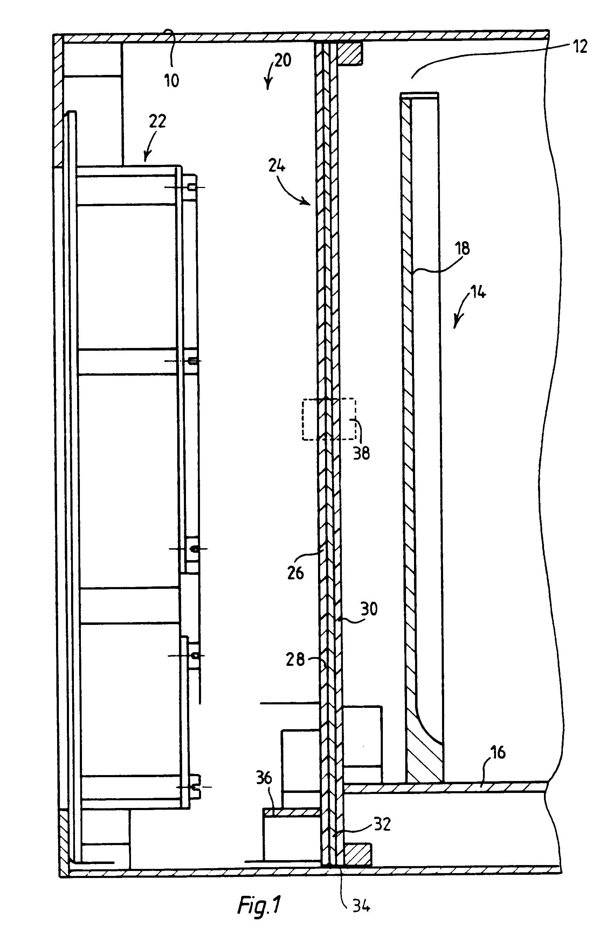

Mit 10 ist ein Gehäuse bezeichnet. Das Gehäuse 10 umschließt einen gegen elektromagnetische Felder abgeschirmten Raum 12. In dem Raum 12 ist ein elektronisches Gerät 14, beispielsweise ein Rechner, angeordnet. Von dem Gerät 14 sind in Fig.1 eine Hauptkarte (Motherboard) 16 und eine Leiterplatte 18 dargestellt.

Außerhalb des abgeschirmten Raumes 12 liegt ein nicht - abgeschirmter Raum 20, in welchem elektromagnetische Felder, u.U. von erheblicher Stärke, auftreten können. An der Vorderseite des Gehäuses 10 ist eine Steckerbuchse 22 vorgesehen, über welche eine Vielzahl von (nicht dargestellten) Signalleitungen anschließbar sind. Zwischen der Steckerbuchse 22 und dem abgeschirmten Raum 12 ist eine abschirmende Trennwand 24 vorgesehen. Die Trennwand 24 gestattet eine Durchführung der verschiedenen Leitungen aus dem nicht - abgeschirmten Raum 20 in den abgeschirmten Raum 12 und zu dem Gerät 14. Dabei erfolgt eine Filterung zur Eliminierung von Störsignalen, welche durch äußere elektromagnetische Felder hervorgerufen werden. Die Trennwand 24 ist von einer mehrschichtigen Leiterplatte 26 gebildet. Die Leiterplatte 26 besteht aus Isolatorschich -ten 28,30 und einer dazwischenliegenden, durchgehenden Masseebene 32 aus gut leitendem Material. Die Masseebene 32 ist an den Rändern der Leiterplatte 26 herausgeführt, wie bei 34 angedeutet, und bildet einen Kontakt, der gut leitend mit dem Gehäuse 10 verbunden ist. Die einzelnen Leitungen sind auf der Außenseite der Leiterplatte 26 zu einer Kontaktleiste 36 geführt und über ein flexibles, vieladriges Kabel (Wire-Wrap oder Flex-Lead) mit der Steckerbuchse 22 verbunden. Auf der Seite des abgeschirmten Raumes 12 sind die Leitungen auf der Innenseite der Leiterplatte 26 zu der Hauptkarte 16 des Gerätes geführt. Auf der Leiterplatte 26 sitzen Filterbauteile 38. Diese Filterbauteile 38 sind als SMD-Bauteile (surface mounted devices) ausgebildet.

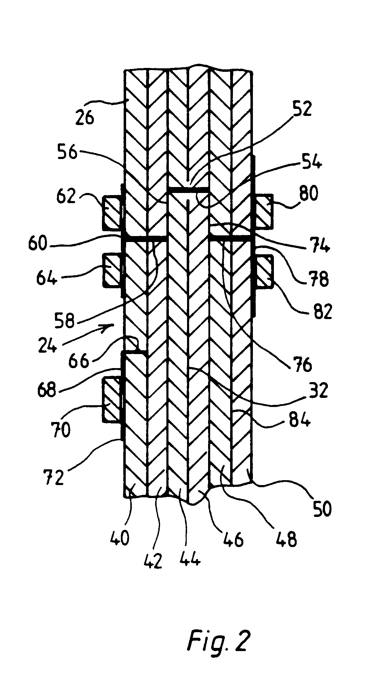

In Fig.2 ist der Aufbau der Trennwand 24 mit der Leiterplatte 26 und den Filterbauteilen und Leitungen für eine Leitung in vergrößertem Maßstab dargestellt.

Die mehrschichtige Filterkarte 26 enthält insgesamt sechs Schichten 40,42.44,46,48 und 50. Die Schichten 40,42,44 bilden dabei die Isolatorschicht 28 von Fig.1. Die Schichten 46,48 und 50 bilden die Isolatorschicht 30 von Fig.1. Die Massefläche 32 erstreckt sich zwischen den Schichten 44 und 46 über die gesamte Fläche der Leiterplatte 26 hinweg.

Die Massefläche 32 weist einen engen Durchbruch 52 auf. Durch diesen Durchbruch 52 erstreckt sich ein Durchsteiger 54 senkrecht zur Ebene der Leiterplatte 26. Der Durchsteiger 54 erstreckt sich durch die Dicke der isolierenden Schichten 44 und 46. Auf der in Fig.2 linken Seite der Schicht 44 ist eine Leiterbahn 56 gebildet. Diese Leiterbahn 56 verläuft bis zu einem Durchsteiger 58. Der Durchsteiger 58 erstreckt sich durch die beiden Schichten 40 und 42 hindurch und ist mit einer Leiterbahn 60 auf der linken Außenseite der Schicht 40 verbunden. Diese Leiterbahn 60 stellt den Kontakt zu Kondensatoren 62 und 64 her, die als SMD-Bauteile ausgebildet und auf der Leiterplatte 26 montiert sind. Auf der in Fig.2 rechten Seite der Schicht 40 ist eine Leiterbahn gebildet, die ebenfalls mit dem Durchsteiger 58 in elektrisch leitendem Kontakt und zu einem Durchsteiger 66 geführt ist. Der Durchsteiger 66 erstreckt sich durch die Schicht 40 nach außen und ist in elektrisch leitender Verbindung mit einer Leiterbahn 68. Die Leiterbahn 68 ist über eine Drossel 70 mit einer Leiterbahn 72 verbunden. Die Drossel ist ebenfalls als SMD-Bauteil ausgebildet und auf der Leiterplatte 26 montiert. Die Leiterbahn 72 bildet einen Teil der zuführenden Leitung. Die Leiterbahn 72 ist daher nach unten in Fig.1 zu der Kontaktleiste 36 geführt und über das flexible Kabel mit einem Kontakt der Steckerbuchse 22 verbunden. Die Bauteile 62,64 und 70 bilden somit ein Filter auf der Außenseite der Leiterplatte 26, also im Bereich des Raumes 20, in welchem elektromagnetische Störfelder auftreten können.

In ähnlicher Weise ist eine Leiterbahn 74 auf der in Fig.2 linken Seite der Schicht 48 mit dem Durchsteiger 52 und einem Durchsteiger 76 elektrisch leitend verbunden. Der Durchsteiger 76 erstreckt sich durch die Schichten 48 und 50. Auf der in Fig.2 rechten Außenseite der Schicht 50 ist eine Leiterbahn 78 gebildet. Die Leiterbahn 78 ist mit dem Durchsteiger 76 sowie mit Kondensatoren 80 und 82 verbunden. Die Kondensatoren 80 und 82 sind als SMD-Bauteile ausgebildet und auf der in Fig.2 rechten Oberfläche der Leiterplatte 26 montiert. Die Kondensatoren 80 und 82 bilden einen Teil eines Filters, das auf der Leiterplatte 26 auf der Seite des abgeschirmten Raumes 12 angeordnet ist. Auf der linken Oberfläche der Schicht 50 ist eine Leiterbahn 84 gebildet. Die Leiterbahn 84 ist ebenfalls in elektrisch leitender Verbindung mit dem Durchsteiger 76. Die Leiterbahn 84 bildet einen Teil der durch die Trennwand 24 hindurchgeführten Leitung und ist nach unten in Fig.1 zu der Hauptkarte 16 geführt.

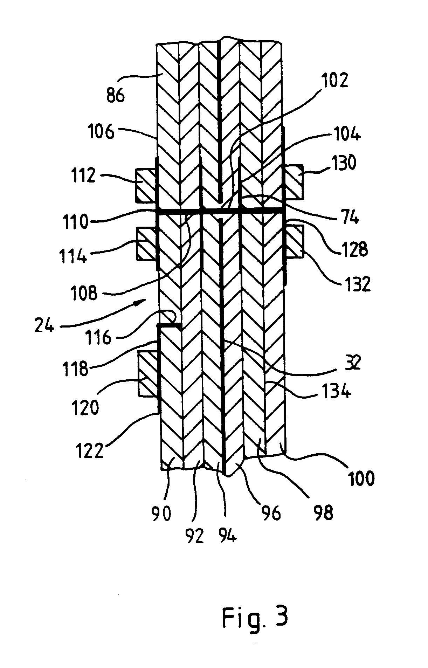

Bei der Ausführung der Trennwand nach Fig.3 ist die Leiterplatte mit 86 bezeichnet.

Die mehrschichtige Leiterplatte 86 weist ebenfalls sechs Schichten 90,92,94,96, 98 und 100. Die Schichten 90,92,94 bilden dabei wieder die Isolatorschicht 28 von Fig.1. Die Schichten 96,98 und 100 bilden die Isolatorschicht 30 von Fig.1. Die Massefläche 32 erstreckt sich zwischen den Schichten 94 und 96 über die gesamte Fläche der Leiterplatte hinweg.

Die Massefläche 32 weist einen engen Durchbruch 102 auf. Durch diesen Durchbruch 102 erstreckt sich ein Durchsteiger 108 senkrecht zur Ebene der Leiterplatte 86.

Der Durchsteiger 108 erstreckt sich hier gerade durch die gesamte Dicke der Leiterplatte 86. Der Durchsteiger 108 ist mit einer Leiterbahn 110 auf der linken Außenseite der Schicht 90 verbunden. Diese Leiterbahn 110 stellt den Kontakt zu Kondensatoren 112 und 114 her. Die Kondensatoren 112 und 114 sind als SMD-Bauteile ausgebildet und auf der Leiterplatte 86 montiert. Das ist ähnlich wie bei der Ausführung nach Fig.2. Auf der in Fig.3 rechten Seite der Schicht 90 ist eine Leiterbahn gebildet, die ebenfalls mit dem Durchsteiger 108 in elektrisch leitendem Kontakt und zu einem Durchsteiger 116 geführt ist. Der Durchsteiger 116 erstreckt sich durch die Schicht 90 nach außen und ist in elektrisch leitender Verbindung mit einer Leiterbahn 118. Die Leiterbahn 118 ist über eine Drossel 120 mit einer Leiterbahn 122 verbunden. Die Drossel 120 ist ebenfalls als SMD-Bauteil, also als oberflächenmontierter Bauteil, ausgebildet und auf der Leiterplatte 86 montiert. Die Leiterbahn 122 bildet wieder einen Teil der zuführenden Leitung ähnlich Leiterbahn 72 in Fig.2. Auch hier bilden die Bauteile 112, 114 und 120 ein Filter auf der Außenseite der Leiterplatte 86, also im Bereich des Raumes 20, in welchem elektromagnetische Störfelder auftreten können.

In ähnlicher Weise ist eine Leiterbahn 128 auf der rechten Seite der Schicht 100 mit dem Durchsteiger 108 elektrisch leitend verbunden. Die Leiterbahn 128 ist weiterhin mit Kondensatoren 130 und 132 verbunden. Die Kondensatoren 130 und 132 sind als SMD-Bauteile ausgebildet und auf der in Fig.3 rechten Oberfläche der Leiterplatte 86 montiert. Die Kondensatoren 130,132 bilden einen Teil eines Filters, das auf der Leiterplatte 86 auf der Seite des abgeschirmten Raumes 12 angeordnet ist. Auf der Linken Oberfläche der Schicht 100 ist eine Leiterbahn 134 gebildet. Die Leiterbahn 134 ist ebenfalls in elektrisch leitender Verbindung mit dem Durchsteiger 108. Die Leiterbahn bildet einen Teil der durch die Trennwand 24 hindurchgeführten Leitung und ist nach unten in Fig.1 zu der Hauptkarte 16 geführt.

Zwischen den Schichten 92 und 94 ist der Durchsteiger 108 mit einer leitenden Fläche 106 elektrisch verbunden. Diese leitende Fläche bildet eine Platte eines Kondensators. Die andere Platte des Kondensators wird durch die Massefläche 32 repräsentiert. Über diesen Kondensator erfolgt eine Ableitung von hochfrequenten Feldern zur Massefläche 32 hin. Die hochfrequenten Felder können nicht einfach längs des Durchsteigers 108 durch den Durchbruch 102 hindurch gerade zu dem abgeschirmten Raum hindurchlaufen. Vielmehr werden die Felder durch die elektrisch leitenden Flächen, ähnlich wie bei der Ausführung nach Fig.2, zu einem "Umweg" um die elektrisch leitende Fläche 106 herum gezwungen.

In ähnlicher Weise ist zwischen den Schichten 92 und 94 der Durchsteiger 108 mit einer leitenden Fläche 104 elektrisch verbunden. Diese leitende Fläche 104 bildet ebenfalls eine Platte eines Kondensators. Die andere Platte des Kondensators wird wieder durch die Massefläche 32 repräsentiert. Über diesen Kondensator erfolgt ebenfalls eine Ableitung von hochfrequenten Feldern zur Massefläche 32 hin. Auch hier werden die hochfrequenten Felder durch die elektrisch leitenden Flächen zu einem "Umweg" um die elektrisch leitende Fläche 104 herum gezwungen.

Die Filter, die von den auf der Oberfläche der Leiterplatte 86 montierten Bauteilen 112,114,120 bzw. 130,132 gebildet werden, sind bei relativ "niedrigen" Frequenzen der störenden hochfrequenten Felder wirksam. Bei Frequenzen etwa von 1 bis 10 Gigahertz sind diese Filter nicht mehr wirksam. Die "Durchlässigkeitskurve" würde wieder ansteigen. Bei diesen Frequenzen sind aber die Kondensatoren, die von den elektrisch leitenden Flächen 104 und 106 zusammen mit der Massefläche gebildet werden, als Filter wirksam.

Diese Kondensatoren können mit üblicher Technik der gedruckten Schaltungen für praktisch beliebig viele Durchführungen hergestellt werden.Die Herstellung solcher Trennwände ist daher im Vergleich zu dem Stand der Technik recht einfach.

## Patentansprüche

1. Filteranordnung zum Filtern einer Mehrzahl von Leitungen, die aus einem elektromagnetische Felder enthaltenden Raum zu einem in einem abgeschirmten Raum befindlichen Gerät geführt sind, enthaltend

(a) eine Trennwand (24) in Form einer mehrschichtigen, mit einer internen Massefläche (32) versehenen Leiterplatte (26) mit Filtergliedern, und

(b) zur Durchführung von Signalen Löcher in der Leiterplatte vorgesehen sind, durch welche Signalleitungen mittels Durchsteiger hindurchgeführt sind, wobei

(c) die Massefläche mit Ausnahme von Durchbrüchen im Bereich der Löcher, durch welche die Durchsteiger hindurchgeführt sind, durchgehend ausgebildet ist und der Abstand der Durchsteiger von der Massefläche so gering ist, daß dort hindurch keine Störfelder in den abzuschirmenden Raum gelangen können und

(d) in der mehrschichtigen Leiterplatte zusätzlich zu der internen Massefläche weitere Schichten mit leitenden Flächen vorgesehen sind, welche mit den Signalleitungen elektrisch verbundene, einen Durchgang hochfrequenter elektromagnetischer Wellen durch die Löcher verhindernde Filterglieder bilden.

2. Filteranordnung nach Anspruch 1, **dadurch gekennzeichnet, daß** bei gerade durchgehenden Löchern die elektrisch leitenden Flächen der weiteren Schichten Kondensatoren zwischen Signalleitung und Massefläche bilden.

3. Filteranordnung nach Anspruch 1 oder 2, **dadurch gekennzeichnet, daß**
(a) die Löcher von engen Sacklochbohrungen gebildet sind, die sich von je einer Seite der Leiterplatte her durch Schichten der Leiterplatte bis zu je einer der an den besagten weiteren Schichten vorgesehenen leitenden Flächen erstrecken,
(b) in der Leiterplatte weitere Bohrungen vorgesehen sind, die sich zwischen den leitenden Flächen an den weiteren Schichten erstrecken und gegenüber den zugehörigen Sacklochbohrungen seitlich versetzt sind, und
(c) Durchsteiger in den Sacklochbohrungen und den besagten weiteren Bohrungen durch die Durchbrüche hindurchgeführt und mit den besagten leitenden Flächen elektrisch verbunden sind.

4. Filteranordnung nach einem der Ansprüche 1 bis 3, **dadurch gekennzeichnet, daß** Filterbauteile (62,64,70, 80,82) als SMD-Bauteile (surface mounted device) ausgebildet und auf der Leiterplatte (26) montiert sind.

5. Filteranordnung nach einem der Ansprüche 1 bis 4, **dadurch gekennzeichnet, daß** Filterbauteile (62,64,70 bzw. 80,82) sowohl auf der Seite des elektromagnetische Felder enthaltenden Raumes (20) als auch auf der Seite des abgeschirmten Raumes (12) angeordnet sind.

6. Filteranordnung nach einem der Ansprüche 1 bis 5, **dadurch gekennzeichnet, daß**
(a) die Massefläche an den Rändern der Leiterplatte nach außen geführt ist und mit einem sich rings um die Leiterplatte erstreckenden elektrisch leitenden Kontakt verbunden ist, und
(b) der sich um die Leiterplatte erstreckende Kontakt auf seinem gesamten Umfang elektrisch gut leitend mit einem abschirmenden Gehäuse verbunden ist.

## Claims

1. Filter arrangement for filtering a plurality of conductors guided from a space comprising electromagnetic fields to an apparatus in a screened space, comprising
(a) a partition (24) in form of a multi-layer printed circuit board provided with an internal grounded surface (32) and filter circuits, and
(b) holes being provided in the printed circuit board for the feeding-through of signals, signal lines being passed, therethrough by means of through-connections wherein
(c) the ground surface is continous exept for apertures in the area of the holes through which the through-connections are guided, and the distance of the through-connections from the grounded surface is so small that no interfering fields get therethrough into the shielded space, and
(d) further layers having conductive surfaces are additionally provided in the multi-layer printed circuit board, these layers forming filter elements electrically connected to the signal lines and preventing passage of high frequency electromagnetic waves through the holes.

2. Filter arrangement as claimed in claim 1, **characterized in that** with straight continous holes, the electrically conducting surfaces of the further layers form capacitors between the signal line and the grounded surface.

3. Filter arrangement as claimed in claim 1 or 2, **characterized in that**
(a) the holes are formed by narrow blind hole bores extending from one side each of the printed circuit board through layers of the printed circuit board to one of the conductive surfaces each provided at the said further layers,

(b) further bores are provided in the printed circuit board and extend between the conductive surfaces on the further layers and are laterally offset with respect to the associated blind hole bores, and

(c) through-connections in the blind hole bores and the said further bores are guided through the apertures and are connected to the said conductive surfaces.

4. Filter arrangement as claimed in one of claims 1 to 3, **characterized in that** filter components (62,64,70,80,82) are formed as SMD components (surface mounted device) and are mounted on the printed circuit board (26).

5. Filter arrangement as claimed in one of claims 1 to 4, **characterized in that** filter components (62,64,70 and 80,82, respectively) are arranged on the side of the space (20) containing electromagnetic fields as well as on the side of the screened space (12).

6. Filter arrangement as claimed in one of claims 1 to 5, **characterized in that**

(a) the grounded surface is guided at the edges of the printed circuit board to the outside and is connected to an electrically conductive contact extending around the printed circuit board, and

(b) the contact extending around the printed circuit board is connected, on its whole circumference, in electrically well conductive way to a screened housing.

**Revendications**

1. Disposition de filtre destinée à filtrer plusieurs conduites guidées d'un espace comprenant des champs électromagnétiques vers un appareil se trouvant dans un espace isolé, comprenant

(a) une paroi de séparation (24) sous forme d'une carte imprimée (26) munie d'une surface de masse interne (32) et de membres de filtre, et

(b) afin d'effectuer des signaux, des trous sont prévus dans la carte imprimée par lesquels sont guidées des conduites de signal au moyen d'éléments de passage, dans laquelle

(c) la surface de masse est formée continuellement à l'exception de percements dans le domaine des trous par lesquels sont guidés les éléments de passage, et l'écart entre les éléments de passage et la surface de masse est aussi petit que des champs perturbateurs ne peuvent passer par ceux-ci dans l'espace à isoler, et

(d) d'autres couches munies de surfaces conductives sont prévues en plus de la surface de masse interne dans la carte imprimée à plusieurs couches, ces couches formant avec la conduite de signal des membres de filtre électriquement reliées évitant le passage d'ondes électromagnétiques à haute fréquence par les trous.

2. Disposition de filtre selon la revendication 1, **caractérisée par le fait que** dans le cas de trous passant étroitement, les surfaces électriquement conductives des autres couches forment des condensateurs entre la conduite de signal et la surface de masse.

3. Disposition de filtre selon la revendication 1 ou 2, **caractérisée par le fait que**

(a) les trous sont formés par des alésages de trou borgne s'étendant respectivement d'un côté de la carte imprimée à travers des couches de la carte imprimée jusqu'à l'une des surfaces conductives prévues sur lesdites autres couches,

(b) d'autres alésages sont prévus dans la carte imprimée, qui s'étendent entre les surfaces conductives sur les autres couches et latéralement déplacés par rapport aux alésages de trou borgne associés, et

(c) des éléments de passage sont guidés dans les alésages de trou borgne et dans lesdits autres alésages à travers les percements et électriquement reliés auxdites surfaces conductives.

4. Disposition de filtre selon l'une des revendications 1 à 3, **caractérisée par le fait que** des composants de filtre (62,64,70,80,82) sont formés comme composants SMD (surface mounted device) et sont montés sur la carte imprimée (26).

5. Disposition de filtre selon l'une des revendications 1 à 4, **caractérisée par le fait que** des composants de filtre (62,64,70 resp. 80,82) sont disposés sur le côté de l'espace (20) comprenant des champs électromagnetiques et sur le côté de l'espace isolé (12).

6. Disposition de filtre selon l'une des revendications 1 à 5, **caractérisée par le fait que**

(a) la surface de masse est guidée sur les bords de la carte imprimée vers l'extérieur et reliée avec un contact électriquement conductif s'étendant autour de la carte imprimée, et

(b) le contact s'étendant autour de la carte imprimée est relié sur tout sa circonférence d'une manière électriquement bien conductive à un boîtier isolé.

Fig.1

Fig. 2

Fig. 3